# EUROPÄISCHE PATENTANMELDUNG

(11) **EP 3 323 721 A1**
(43) Veröffentlichungstag der Anmeldung: **23.05.2018**
(21) Anmeldenummer: 17150368.3
(22) Anmeldetag: 05.01.2017
(51) Int. Cl.: B64D 7/00, F41H 3/00, H05K 9/00

(54) **PRINZIP FÜR DIE GESTALTUNG VON AERODYNAMISCH VORTEILHAFTE KÖRPER UND KONTUREN VON FLUGZEUGEINRICHTUNGEN UND DIE NUTZUNG VON STEALTH-TECHNOLOGIE**

(30) Priorität: 21.11.2016 EP 16199727
(71) Anmelder: Shchukin, Anton Alexandrovich, 184635 pos. Roslyakovo-1 (RU)
(72) Erfinder: Shchukin, Anton Alexandrovich, 184635 pos. Roslyakovo-1 (RU)
(74) Vertreter: Hertin und Partner Rechts- und Patentanwälte PartG mbB

(57) **Zusammenfassung**

Die Erfindung betrifft ein Flugzeug oder Flugzeugteil dessen äußere Oberfläche aus radio- und/oder strahlungstransparentem Material hergestellt ist und auf dessen Innenseite eine Beschichtung auf radio- und/oder strahlungsreflektierendem Material angeordnet ist sowie die Verwendung eines solchen Flugzeugs oder Flugzeugteils.

## Beschreibung

### Stand der Technik

Tarnkappenflugzeug oder Stealthflugzeug ist die Bezeichnung für ein Flugzeug, das die Tarnkappentechnik nutzt. Dies geschieht mittels besonderer geometrischer Formgebung und der Oberflächenbeschaffenheit, so dass das Flugzeug für ein Radar nur auf kurze Distanzen zu erfassen ist.

Tarnkappenflugzeuge werfen generell nur ein geringes Maß an Wellen zum Sender zurück. Bei elektromagnetischen Wellen sorgt meist eine spezielle Elektronik dafür. Auch die äußere Form trägt erheblich dazu bei, dass weniger elektromagnetische Wellen reflektiert werden als bei herkömmlichen Flugzeugen. Außerdem werden spezielle radarabsorbierende Materialien (RAM) auf der Oberfläche eingesetzt, um den Radarquerschnitt zu verringern. Darüber hinaus werden besonders leise Triebwerke genutzt. Der Abgasstrahl dieser Triebwerke wird durch besondere Vorkehrungen kühl gehalten und entweicht zum Boden hin abgeschirmt, um Infrarotdetektoren eine möglichst geringe Infrarotsignatur zu bieten. Zudem sorgt die Verwendung von Verbundwerkstoffen anstelle von Metall für eine geringe Radarsignatur.

Es ist bekannt, dass um Unsichtbarkeit für ein Flugzeug in einem bestimmten Bereich der Strahlung zu erreichen, man auch das Design seiner Konturen mit dem effektivsten Profil nutzt. Leider ist diese Form nicht immer aerodynamisch optimal um die besten Flugeigenschaften des Flugzeugs zu gewährleisten. Darüber hinaus werden die Reflexionsflächen bei Start und Landung durch Schmutzpartikel verkratzt und beschädigt, werden abgebaut, werden durch Nieten verbunden oder verlieren auf andere Weise ihre Wirksamkeit.

Es war daher die Aufgabe der Erfindung, ein Flugzeug oder ein Flugzeugteil bereitzustellen, das einen radio- und/oder funktransparenten Körper liefert und gleichzeitig die Nachteile des Standes der Technik überwindet.

Diese Aufgabe wird gelöst durch die unabhängigen Ansprüche. Bevorzugte Ausführungsformen finden sich in den abhängigen Ansprüchen

### Beschreibung der Erfindung

In einer ersten bevorzugten Ausführungsform betrifft die Erfindung ein Flugzeug oder Flugzeugteil dadurch gekennzeichnet, dass die äußere Oberfläche des Flugzeugs oder Flugzeugteils aus radio- und/oder strahlungstransparentem Material hergestellt ist und auf der Innenseite des Flugzeugs oder Flugzeugteils eine Beschichtung aus radio- und/oder strahlungsreflektierendem Material angeordnet ist.

Das gegebene Prinzip der Herstellung von Flugzeugen oder Flugzeugteilen ermöglicht es, die Reflexionsflächen im Inneren des Flugzeugs bzw. des Flugzeugteils anzuordnen, nämlich im Inneren eines funktransparenten Körpers des Flugzeugs.

Dadurch wird zu einem sichergestellt, dass das Flugzeug die optimale aerodynamische Form und Qualitäten aufweisen kann, sodass die Flugeigenschaften nicht behindert werden. Gleichzeitig ermöglicht die Erfindung einen Schutz der Hochreflexionsflächen vor physikalischen oder anderen Einflüssen von außen. Schmutzpartikel die sich vor allem bei Start und Landung auf der Oberfläche des Flugzeugs sammeln, haben keinen störenden Einfluss mehr auf die Reflexionsflächen, da diese im Inneren geschützt vorliegt.

Als Folge davon kann man eine praktisch ideal "spiegelnde" reflektierende Oberfläche erreichen, die geringes Gewicht aufweist und absolut nicht die Flugeigenschaften des Flugzeugs in irgendeiner Weise beeinflusst.

Hierzu weisen die erfindungsgemäßen Flugzeuge oder Flugzeugteile zwei Profile auf: ein äußeres und ein inneres. Das äußere Profil ist so konstruiert, dass es die aerodynamisch vorteilhaften Eigenschaften ermöglicht und aus radio-transparentem Material hergestellt ist. Das innere Profil ist hingegen so konstruiert, dass es die effizienteste funkreflektierende Form aufweist und mit radio-reflektierendem Material beschichtet ist. Beispielsweise kann dies ein Flügel aus einer radio-transparent Carbonverbindung sein, wobei das Außenprofil die aerodynamischen Anforderungen erfüllt, während das Innenprofil die Anforderungen für die Gewährleistung der radioelektronischen Unsichtbarkeit erfüllt.

In einer weiteren bevorzugten Ausführungsform sind funkemittierende Elemente und/oder Mechanismen im Inneren des Flugzeug oder Flugzeugteils angeordnet.

Außerdem bevorzugt ist die Innenseite des Flugzeug oder Flugzeugteils zusätzlich mit einer oder mehreren Schutzschichten beschichtet.

Es ist weiterhin bevorzugt, dass keine Radio- und/oder Funkstrahlung aus dem Flugzeug oder Flugzeugteil nach außen dringt.

Außerdem bevorzugt ist, dass die strahlungsreflektierende Schicht vor mechanischen Schäden schützt.

Besonders bevorzugt ist, dass das radio-transparente Material eine Carbonverbindung umfasst.

In einer weiteren bevorzugten Ausführungsform betrifft die Erfindung die Verwendung eines beschriebenen Flugzeugs oder Flugzeugteils zur Schaffung eines radio-undurchsichtigen Innenvolumens.

Die Erfindung erzielt unter anderem die folgenden Vorteile:
- Die erforderlichen aerodynamischen Eigenschaften des Flugzeugs werden nicht beeinträchtigt. Die notwendige strukturelle Festigkeit wird erzielt.
- Das erforderliche Qualitätsniveau der Radio- und/oder Funkreflexion des Flugzeugs wird erreicht.
- Der erforderliche Grad der Maskierung seiner internen Strukturen, Teile, Elemente und Mechanismen wird erreicht.
- Eine hohe Qualität der funkreflektierenden Oberfläche des Flugzeugs kann erzielt werden.
- Ein hohes Schutzniveau der Hochreflexionsfläche des Flugzeugs wird erreicht.
- Die äußeren Einflüsse auf die Hochreflexionsfläche werden minimiert.

Die Schaffung eines radio-undurchsichtigen Innenvolumen des Flugzeugs wird durch die erfindungsgemäßen Ausführungsformen erreicht. Dadurch wird eine Maskierung der funkemittierenden Mechanismen, Elemente und Teile innerhalb dieses Innenraumes möglich.

Die Erfindung liefert ein Prinzip für die Gestaltung eines aerodynamisch vorteilhaften Körpers eines Flugzeugs (z.B. Rumpf) oder eines Elements oder Teils davon oder einer Flugzeugvorrichtung, wobei diese Teile aus radiotransparentem Materialien hergestellt sind. Dadurch können Flugzeugteile bereitgestellt werden, die eine wünschenswerte und vorteilhafte Kontur zur Reflexion von Radio- oder Funkstrahlung aufweisen. Dazu umfasst das Flugzeugteil ein oder mehrere radioreflektierende Materialien. Die Erfindung ermöglicht somit, dass notwendige oder optionale Flugzeugmechanismen und Vorrichtungen in einer Zone angeordnet werden, die vollständig von Ortungsstrahlung oder andere Strahlung geschützt ist.

Das Profil des Flugzeugs oder Flugzeugteils (z.B. des Flugzeugflügels) ist so ausgebildet, dass die Außenseite maximal aerodynamisch vorteilhaft ist und es aus einem radio-transparenten Material besteht, z.B. einem Verbundstoff. Der Verbundstoff muss gewisse Festigkeitseigenschaften und andere Eigenschaften, die für die Gestaltung der gegebenen Vorrichtung optimal sind, mit sich bringen. Ein Fachmann weiß, wie er dieses Material auswählt ohne dabei selbst erfinderisch tätig zu werden.

In diesem Körper, wird ein Profil mit Eigenschaften gebildet, die es erlauben, einen Innenraum bereitzustellen, der in optimaler Weise bestimmte Strahlung reflektiert. Die Wände dieses Innenraums werden dafür mit einem radioreflektierenden Material beschichtet (beispielsweise mit Hilfe der Reaktion eines Silberspiegels, oder durch eine Beschichtung mit Platten aus einem geeigneten Material). Dadurch ermöglicht es die Erfindung einen praktisch ideal reflektierenden Spiegel bereitzustellen, welcher vor äußeren physikalischen Einflüssen geschützt ist.

In einer besonders bevorzugten Ausführungsform ist diese "Spiegelschicht" zusätzlich durch eine oder mehrere Schutzschichten überzogen. Der Fachmann weiß, in welchen Fällen eine Beschichtung mit zusätzlichen Substanzen notwendig sein kann, ohne dabei selbst erfinderisch tätig zu werden.

In diesem Raum, der von der Funkstrahlung geschützt ist, können gegebenenfalls Vorrichtungen, die für das gegebene Flugzeug erforderlich oder nützlich sind, angeordnet werden. Außerdem können zusätzlich Mechanismen, einschließlich Leistungskomponenten dort angeordnet bzw. umgesetzt werden. In einem solchen Fall kann der Reflexionskoeffizient nahe bei eins sein, so dass die Strahlenbelastung der internen Vorrichtungen und Mechanismen vollständig verhindert wird, und als Ergebnis, die Reflexion dieser Strahlung von diesen Vorrichtungen und Mechanismen verhindert werden, wobei eine solche reflektierte Strahlung nicht anfällig für Detektion sind. Darüber gelangt Strahlung aus dem Innenraum nicht nach außen.

Durch das erfindungsgemäße Prinzip wird es möglich unterschiedliche Flugzeugkomponenten wie z.B. Flugzeugflügel, den Flugzeugrumpf, Leitwerke, das Flugzeugheck, andere mechanische Komponenten, Hängecontainer sowie sämtliche anderen Teile, Komponenten oder Zubehör eines Flugzeugs.

Es ist in einer besonders bevorzugten Ausführungsform vorgesehen, dass die strahlungsreflektierende Beschichtung das Flugzeug Teil zusätzlich vor mechanischen Schäden schützt.

In einer weiteren bevorzugten Ausführungsform der Erfindung können radio- oder funkemittierende und radio- oder funkempfangenden Elemente von Mechanismen oder Geräten außerhalb des strahlungsdichten Körpers angeordnet werden.

Im Folgenden wird die Erfindung anhand einer Abbildung näher erläutert, ohne dass die Erfindung auf diese Ausführungsform beschränkt ist.

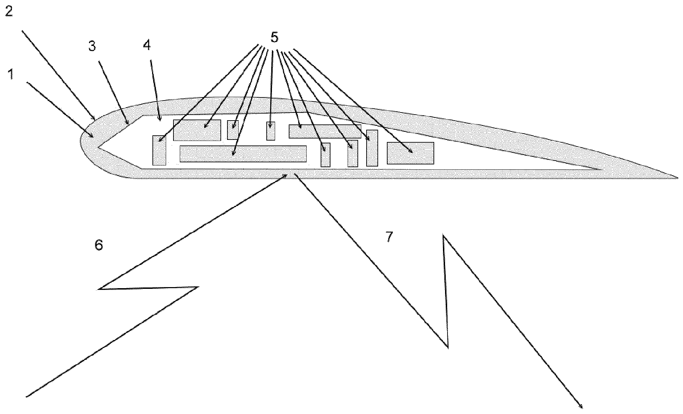

Figur 1 zeigt eine schematische Darstellung eines Flugzeugflügels in einer bevorzugten Ausführungsform der Erfindung. Der Flugzeugflügel umfasst radiotransparentes Material 1. Außerdem weist er eine aerodynamisch vorteilhafte Form 2 auf. Eine strahlungsreflektierende Beschichtung 3 ist auf der inneren Oberfläche des Flügels aufgetragen. Der Innenraum 4 des Flügels ist vor Strahlung 6 geschützt. Vorrichtungen und Mechanismen 5 sind im geschützten Innenraum 4 des Flügels angeordnet. Ortungsstrahlungen oder andere Strahlungen 6 werden als reflektierte Strahlung 7 zurückgeschickt.

### Bezugszeichenliste:

1 Radiotransparentes Material
2 aerodynamisch vorteilhafte Form des Flügels
3 radioreflektierend Beschichtung auf der Flügelinnenfläche
4 Innenraum des Flügels
5 Geräte und Mechanismen, die innerhalb des Innenraums des Flügels angeordnet sind
6 Radiostrahlung
7 reflektierte Radiostrahlung

## Patentansprüche

1. Flugzeug oder Flugzeugteil **dadurch gekennzeichnet, dass** die äußere Oberfläche des Flugzeugs oder Flugzeugteils aus radio- und/oder strahlungstransparentem Material hergestellt ist und auf der Innenseite des Flugzeugs oder Flugzeugteils eine Beschichtung aus radio- und/oder strahlungsreflektierendem Material angeordnet ist.

2. Flugzeug oder Flugzeugteil nach Anspruch 1, **dadurch gekennzeichnet, dass** funkemittierende Elemente und/oder Mechanismen im Inneren des Flugzeug oder Flugzeugteils angeordnet sind.

3. Flugzeug oder Flugzeugteil nach Anspruch 1 oder 2, **dadurch gekennzeichnet, dass** die Innenseite des Flugzeug oder Flugzeugteils zusätzlich mit einer oder mehreren Schutzschichten beschichtet ist.

4. Flugzeug oder Flugzeugteil nach mindestens einem der vorhergehenden Ansprüche, **dadurch gekennzeichnet, dass** keine Radio- und/oder Funkstrahlung aus dem Flugzeug oder Flugzeugteil nach außen dringt.

5. Flugzeug oder Flugzeugteil nach mindestens einem der vorhergehenden Ansprüche, **dadurch gekennzeichnet, dass** die strahlungsreflektierende Schicht vor mechanischen Schäden schützt.

6. Flugzeug oder Flugzeugteil nach mindestens einem der vorhergehenden Ansprüche, **dadurch gekennzeichnet, dass** das radio-transparente Material eine Carbonverbindung umfasst.

7. Flugzeugteil nach mindestens einem der vorhergehenden Ansprüche, **dadurch gekennzeichnet, dass** das Flugzeugteil ein Flugzeugflügel, ein Flugzeugrumpf, ein Leitwerk, ein Flugzeugheck, ein Hängecontainer oder ein Zubehörteil eines Flugzeugs ist.

8. Verwendung eines Flugzeugs oder Flugzeugteils nach mindestens einem der vorherigen Ansprüche, zur Schaffung eines radio-undurchsichtigen Innenvolumens.
